# EUROPÄISCHE PATENTSCHRIFT

(11) **EP 3 107 218 B1**
(45) Veröffentlichungstag und Bekanntmachung des Hinweises auf die Patenterteilung: **14.06.2023**
(21) Anmeldenummer: 15172905.0
(22) Anmeldetag: 19.06.2015
(51) Int. Cl.: H04B 3/54, H03K 5/00

(54) **VERFAHREN UND VORRICHTUNG ZUR DATENÜBERTRAGUNG SOWIE ZÄHLEREINHEIT**
METHOD AND DEVICE FOR TRANSMITTING DATA AND COUNTER UNIT
PROCEDE ET DISPOSITIF DE TRANSMISSION DE DONNEES ET UNITE DE COMPTAGE

(43) Veröffentlichungstag der Anmeldung: 21.12.2016
(73) Patentinhaber: GWF AG, 6002 Luzern (CH)
(72) Erfinder: Mathis, Peter, 6362 Stansstad (CH)
(74) Vertreter: Inventio AG

(56) Entgegenhaltungen:
- CN-U- 202 475 383
- US-A1- 2007 239 318

## Beschreibung

Die Erfindung betrifft ein Verfahren zur Datenübertragung zwischen einer ersten und wenigstens einer zweiten Kommunikationseinheit, insbesondere ein Verfahren zur unidirektionalen oder bidirektionalen Übertragung von Daten zwischen einer Leseeinheit und einer Zählereinheit, mittels der z.B. der Verbrauch eines flüssigen oder gasförmigen Mediums, wie Gas oder Wasser, oder der Verbrauch von elektrischer oder thermischer Energie messbar ist.

Die DE19922603A1 z.B. offenbart ein Verfahren sowie eine Vorrichtung zur Fernablesung eines Verbrauchszählers bzw. einer Zählereinheit, deren Zählerdaten erfasst und über eine Datenfernübertragungsstrecke zu einem Fernablesemodul bzw. zu einer Leseeinheit übertragbar sind.

Die Leseeinheit und die Zählereinheit können dabei galvanisch über durchgehende Leitungen oder induktiv miteinander gekoppelt sein. Die induktive Kopplung erlaubt es, eine mit einer mobilen Leseeinheit verbundene erste Kopplungsspule bedarfsweise an eine stationär installierte zweite Kopplungsspule anzukoppeln, über die Zählerdaten aus der Zählereinheit ausgelesen werden können. Bei galvanischer Kopplung können Zählerdaten mittels eines geschalteten Gleichspannungssignals ohne Trägersignal übertragen werden. Bei induktiver Kopplung wird ein Trägersignal übertragen, welches mittels der zu übertragenden Zählerdaten moduliert wird. Das von der Leseeinheit abgegebene Gleichspannungssignal bzw. Trägersignal kann ferner zur Fernspeisung der Zählereinheit verwendet werden, falls diese nicht über eine eigene Stromversorgung verfügt.

Mittels einer Leseeinheit können zudem eine oder mehrere Zählereinheit über ein entsprechend ausgestaltetes Netzwerk ausgelesen werden. Zur Anwendung gelangen unterschiedliche Netzwerk-Topologien, wie die Stern-Topologie, die Ring-Topologie oder die Bus-Topologie.

Für die Übertragung von Daten können verschiedene Protokolle zur Anwendung gelangen. Das Kommunikationsprotokoll kann mehrere Kommunikationsschichten definieren, die z.B. gemäss dem OSI-Modell strukturiert sind.

Ein für Zähler häufig genutzter Übertragungsstandard ist der M-Bus (kurz für Meter-Bus), der in der Normenreihe EN13757 spezifiziert ist. Über den M-Bus können nicht nur Zählerdaten aus Zählern ausgelesen und auf eine Leseeinheit übertragen werden, sondern es können auch Steuerbefehle an verschiedene Sensoren und Aktoren innerhalb des Kommunikationssystems gesendet werden, um damit z.B. den Verbrauchsfluss innerhalb des Versorgungssystems fernzusteuern.

Der M-Bus ist ein hierarchisches System, das von einem Master gesteuert wird, der über eine Übertragungsleitung mit einem oder mehreren Slaves verbunden ist. Der Master dient dabei als Leseeinheit, welche Daten aus den Slaves auslesen kann, die in der Ausgestaltung der oben beschriebenen Zählereinheit vorliegen können. Die Kommunikation zwischen dem Master und den Slaves erfolgt seriell über eine Übertragungsleitung. Zur Übertragung von Daten und elektrischer Energie vom Master zu den Slaves wird vom Master eine Gleichspannung an die Übertragungsleitung angelegt, die in Abhängigkeit der zu übertragenden Daten zwischen 36 V und 24 V umgeschaltet wird. Eine logische "1" korrespondiert zur höheren Spannung von 36 V, während eine logische "0" zur tieferen Spannung von 24 V korrespondiert. Für Datenbits, die von den Slaves zum Master gesandt werden, wird der Stromkonsum der Slave entsprechend moduliert. Einer logisch "1" entspricht ein Stromkonsum von 1.5 mA und einer logisch "0" entspricht ein zusätzlicher Stromkonsum im Bereich von 11 bis 20 mA. Bei der Übertragung einer logisch "0"resultiert eine geringfügige Reduktion der Spannung aufgrund der Busimpedanz.

Ein weiteres Übertragungsverfahren ist bekannt, bei dem der Master bzw. die Leseeinheit ein Wechselspannungssignal oder eine Gleichspannung an die Übertragungsleitung anlegt, die in festen oder variablen Zeitabständen unterbrochen wird, sodass Zeitfenster resultieren, innerhalb denen der Slave bzw. die Zählereinheit Daten zur Leseeinheit übertragen kann.

Die Überwachung des Datenübertragungsvorgangs, z.B. die Ermittlung der Zeitfenster, innerhalb denen Daten übertragbar sind, erfolgt in der Zählereinheit mittels eines Prozessors, üblicherweise mittels eines Signalprozessors. Leistungsfähige Prozessoren, insbesondere Signalprozessoren, sind dabei problemlos in der Lage, den Datenübertragungsvorgang überwachen und steuern zu können, falls sie nicht anderweitige Aufgaben erfüllen müssen. Diese Prozessoren sind jedoch teuer und benötigen während der kontinuierlichen Überwachung der Datenströme viel elektrische Leistung.

Aufgrund der hohen Verlustleistungen der Prozessoren muss von der Leseeinheit zudem eine entsprechend ausgestaltete Stromversorgung zur Verfügung gestellt werden.

Aus der CN202475383U ist eine M-Bus Master Station bekannt.

Die US2007239318A1 betrifft einen Empfänger für ein Bussystem, insbesondere den M-Bus.

Der vorliegenden Erfindung liegt daher die Aufgabe zu Grunde, die Nachteile des Standes der Technik zu überwinden und ein verbessertes Verfahren und eine verbesserte Vorrichtung zur Datenübertragung zwischen einer ersten Kommunikationseinheit, z.B. einer Leseeinheit, und wenigstens einer zweiten Kommunikationseinheit, z.B. einer Zählereinheit, bereitzustellen. Ferner ist eine verbesserte Zählereinheit zu schaffen, aus der mittels des erfindungsgemässen Verfahrens Zählerdaten auslesbar sind.

Die erfindungsgemässe Zählereinheit soll mit kostengünstigen Prozessoren ausgestattet werden können, die mit relativ tiefen Taktfrequenzen arbeiten können und nur einen geringen Energiebedarf und eine geringe Verlustleistung aufweisen.

Bei der Anwendung des erfindungsgemässen Verfahrens und der entsprechenden Übertragung von Daten und Signalen zwischen der Leseeinheit und der Zählereinheit soll nur wenig Prozessorleistung des in der Zählereinheit vorgesehenen zentralen Prozessoreinheit in Anspruch genommen werden, sodass relativ viel Prozessorleistung für weitere Aufgaben, insbesondere Metering-Aufgaben zur Verfügung steht oder ein weniger leistungsfähige Prozessor verwendbar ist.

Diese Aufgabe wird durch das Verfahren gemäss Anspruch 1, die Vorrichtung gemäss Anspruch 11 und die Zählereinheit gemäss Anspruch 13 gelöst. Vorteilhafte Ausgestaltungen der Erfindung sind in weiteren Ansprüchen angegeben.

Das Verfahren dient der Übertragung von Signalen und Daten innerhalb wenigstens einer ersten und einer zweiten Übertragungsphase, die synchron oder asynchron aufeinander folgen, zwischen einer ersten Kommunikationseinheit und wenigstens einer zweiten Kommunikationseinheit, die eine zentrale Prozessoreinheit CPU (nachstehend nur CPU), eine Speichereinheit, in der ein Betriebsprogramm abgelegt ist, und wenigstens einen ersten Ereignisgenerator umfasst, der über eine Übertragungsleitung zwischen den beiden Kommunikationseinheiten übertragene Signalfolgen unabhängig von der zentralen Prozessoreinheit überwacht und für Ereignisse während der Datenübertragung, die gemäss dem angewendeten Übertragungsprotokoll auftreten, Ereignismeldungen generiert, die zur zentralen Prozessoreinheit und/oder zu wenigstens einem Ereignisanwender übertragen werden.

Mittels des Ereignisgenerators kann somit die gemäss dem Übertragungsprotokoll durchgeführte Übertragung von Signalen auf der Übertragungsleitung überwacht werden, während die CPU weitere Prozesse bearbeitet oder ruht. Z.B. kann die CPU parallel Aufgaben der zweiten Kommunikationseinheit, z.B. eine Zählerfunktion erfüllen.

Mittels des wenigstens einen Ereignisgenerators können beliebige Ereignisse detektiert werden, die gemäss dem Übertragungsprotokoll auftreten können. Das Übertragungsprotokoll kann Vorgänge spezifizieren, die den Wechsel der Übertragungsphasen und/oder die Übertragung von Daten betreffen, wie dies eingangs für den M-Bus beschrieben wurde. Daten können beispielsweise in einer Rahmenstruktur übertragen werden. Ferner können Startsequenzen definiert werden, mittels denen der Beginn einer Datenübertragung signalisiert wird. Mittels des Ereignisgenerators oder den Ereignisgeneratoren kann das Auftreten dieser im Übertragungsprotokoll spezifizierten Ereignisse, wie das Eintreffen eines Headers eines Datenrahmens, das Eintreffen oder das Fehlen einer Signalflanke, das Auftreten der Adresse der zweiten Kommunikationseinheit oder das Eintreffen von Daten, erkannt werden. In der Folge können mittels der abgegebenen Ereignismeldungen die erforderlichen Massnahmen durchgeführt werden. Insbesondere kann eine Rückübertragung von Daten, wiederum gemäss dem Übertragungsprotokoll, erfolgen.

Vorzugsweise wird mittels wenigstens eines der Ereignisgeneratoren das Auftreten der zugehörigen Adresse der zweiten Kommunikationseinheit innerhalb der ersten Signalfolge detektiert. Vorzugsweise werden nur nach Detektion der zugehörigen Adresse die weiteren Verfahrensschritte durchgeführt und für die weiteren Ereignisse während der Datenübertragung der ersten Signalfolge Ereignismeldungen erzeugt, die die Übertragung der zweiten Signalfolge von der adressierten zweiten Kommunikationseinheit zur ersten Kommunikationseinheit auslösen.

Sofern die zweite Kommunikationseinheit innerhalb einer Netz-Topologie mit wenigstens einer weiteren zweiten Kommunikationseinheiten mit der ersten Kommunikationseinheit verbunden ist, kann daher jeweils die adressierte zweite Kommunikationseinheit gespeicherte Daten zur ersten Kommunikationseinheit übertragen. Sofern die zweiten Kommunikationseinheiten zum Zweck der Reduktion des Energieverbrauchs jeweils teilweise in einen Schlafmodus versetzt werden, können diese durch Übertragung der entsprechenden Adresse vorteilhaft wieder aktiviert werden. Auf diese Weise können die zweiten Kommunikationseinheiten in einer beliebigen Netz-Topologie somit selektiv abgefragt werden.

Zur Detektion der Adresse kann ein Ereignisgenerator mit einem Schieberegister verwendet werden, in das eine von der ersten Kommunikationseinheit übertragene Datenfolge eingeführt wird. Durch Vergleich der Daten im Schieberegister mit den Daten eines Registers, in das die zugehörigen Adresse einprogrammiert ist, kann das Auftreten dieser Adresse detektiert werden.

Mittels der Ereignisgeneratoren können zudem zusätzlich Ereignisse überwacht werden, die nicht im Übertragungsprotokoll spezifiziert sind. Vorteilhaft kann eine Fehlerüberwachung erfolgen. Z.B. kann das Auftreten von Überspannungen auf der Übertragungsleitung überwacht und der ersten Kommunikationseinheit gemeldet werden.

Der Ereignisgenerator kann z.B. als Filter, insbesondere als Hüllkurvenfilter, oder als Hüllkurvendetektor ausgebildet sein und dadurch die zu den Übertragungsphasen korrespondierende Hüllkurve oder Teile dieser Hüllkurve einer von der ersten Kommunikationseinheit zur zweiten Kommunikationseinheit übertragenen ersten Signalfolge ermitteln.

Anhand der ermittelten Hüllkurve oder Teilen davon gelingt es z.B., die erste Übertragungsphase, in der Signale von der ersten zur zweiten Kommunikationseinheit übertragen werden, und die zweite Übertragungsphase, in der Signale und Daten von der zweiten zur ersten Kommunikationseinheit übertragbar sind, zu bestimmen.

Für die Übertragung von Daten von der zweiten zur ersten Kommunikationseinheit sowie für weitere Aufgaben können in der zweiten Kommunikationseinheit Ereignisanwender eingesetzt werden, die ebenfalls Dienste für die CPU zur Verfügung stellen und entsprechende Aktionen ausführen.

Für den Datenaustausch zwischen dem Ereignissystem und der CPU können ebenfalls Ereignisgeneratoren und Ereignisanwender eingesetzt werden, die als I/O (Input/Output) Einheiten ausgebildet sind. Sofern ein Ereignisgenerator eine Ereignismeldung erzeugt hat, kann ein Ereignisanwender, der als I/O Einheit ausgebildet ist, diese Ereignismeldung zur CPU übertragen. Alternativ kann ein Ereignisgenerator, der als I/O Einheit ausgebildet ist, Instruktionen von der CPU entgegennehmen und als Ereignismeldung einem Ereignisanwender zuführen.

Mittels einer Ereignismeldung, die der CPU zugeführt wird, wird z.B. ein Interrupt ausgelöst, der dazu führt, dass ein von der CPU ausgeführter Hauptprozess unterbrochen und dazwischen eine durch den Interrupt bestimmte Subroutine ausgeführt wird. Nach Ausführung der Subroutine wird der Hauptprozess nach der zuletzt ausgeführten Programmzeile weitergeführt.

Ereignisgeneratoren und Ereignisanwender können daher miteinander und auch mit der zentralen Prozessoreinheit CPU kommunizieren. Diese Kommunikation erfolgt vorzugsweise über einen Ereignismanager, der als Router oder Multiplexer ausgebildet ist.

Die Ereignisgeneratoren und Ereignisanwender stellen der CPU somit Dienste zur Verfügung und entlasten die CPU von den entsprechenden Aufgaben.

Die erste Kommunikationseinheit ist vorzugsweise als Leseeinheit ausgebildet, die nach dem erfindungsgemässen Verfahren Daten aus der zweiten Kommunikationseinheit auslesen kann, die vorzugsweise als Zählereinheit ausgebildet ist. Obwohl das erfindungsgemässe Verfahren mit beliebigen Kommunikationseinheiten einsetzbar ist, die unterschiedliche Aufgaben erfüllen können, werden die erste Kommunikationseinheit nachstehend als Leseeinheit und die zweite Kommunikationseinheit als Zählereinheit genannt, ohne dass dadurch eine Einschränkung erfolgen soll.

Da Ereignisse während der Datenübertragung, die für das angewendete Übertragungsprotokoll relevant sind, oft in zeitlich grossen Abständen auftreten, wird für die Erledigung von Prozessoraufgaben, welche für die Datenübertragung benötigt werden, anteilsweise nur wenig Prozessorzeit aufgewendet. Das erfindungsgemässe Verfahren kann dabei mit beliebigen Übertragungsprotokollen, wie dem eingangs beschriebenen M-Bus-Protokoll, angewendet werden. Wesentlich ist, dass während der Datenübertragung die auf dem Protokoll basierenden Ereignisse detektiert werden können. D.h., die Ereignisgeneratoren sind entsprechend auszugestalten und zu konfigurieren. Z.B. werden Ereignisgeneratoren in der Ausgestaltung von Filtern oder Detektoren verwendet, die vorteilhaft mittels Timereinheiten realisiert werden können.

Vorzugsweise wird ein Prozessormodul, z.B. der Mikrocontroller AVR10001 von Atmel, eingesetzt, welcher nebst der CPU ein Ereignissystem mit Ereignisgeneratoren und Ereignisanwendern umfasst, die für das erfindungsgemässe Verfahren eingesetzt werden können.

In vorzugsweisen Ausgestaltungen werden Ereignisgeneratoren und Ereignisanwender verwendet, die vorzugsweise mittels des Betriebsprogramms individuell programmierbar oder konfigurierbar sind, sodass sie in jeder Phase des Prozesses der Datenübertragung die zugeordnete Aufgabe erfüllen können. Z.B. wird ein Ereignisgenerator vorgesehen, welcher die Übertragung von Signalfolgen einer ersten Frequenz innerhalb der ersten Übertragungsphase und die Übertragung von Signalfolgen einer zweiten Frequenz innerhalb der zweiten Übertragungsphase überwacht, um das Ende jeder Übertragungsphase zu bestimmen und/oder in den Signalfolgen enthaltene Daten detektieren zu können. Der Ereignisgenerator, z.B. eine darin vorgesehene Timereinheit oder eine Filtereinheit wird daher für jede Übertragungsphase entsprechend den auftretenden Frequenzen konfiguriert. Sofern Timereinheiten vorgesehen sind, werden deren Taktfrequenzen z.B. proportional zu den Frequenzen der Signale gewählt, die auf der Übertragungsleitung auftreten.

Z.B. wird eine Timereinheit vorgesehen, die mittels eines Taktsignals getaktet wird und die mittels einer entsprechenden Flanke der über die Übertragungsleitung übertragenen Signalfolge zu entsprechenden Zeitpunkten rücksetzbar ist und an deren Ausgang Zählerstände gebildet werden, die mit einem Schwellwert verglichen werden, um ein Ereignis während der Datenübertragung, insbesondere das Ausbleiben der entsprechenden Flanke zu detektieren. Sofern ein Rechtecksignal von der Leseeinheit zur Zählereinheit übertragen wird, wird die Timereinheit z.B. mit jeder ansteigenden Flanke zurückgesetzt. Sofern eine ansteigende Flanke nicht mehr eintrifft, zählt die Timereinheit weiter hoch, bis der Schwellwert oder ein Timeout erreicht ist. Zu diesem Zeitpunkt kann der Zustand des Signals auf der Übertragungsleitung geprüft und festgestellt werden, ob eine Zustandsänderung erfolgt ist.

Der erste Ereignisanwender umfasst vorzugsweise wenigstens eine zweite Timereinheit, die mittels eines Taktsignals getaktet wird und mittels der eine zweite Signalfolge erzeugt wird, die entsprechend den zu übertragenden Daten moduliert wird oder gewählt ist und in der Folge für eine bestimmte Zeitdauer zur Leseeinheit übertragen wird. Diese Zeitdauer wird vorzugsweise mittels eines zweiten Ereignisanwenders anhand einer dritten Timereinheit festgelegt. D.h., mit Beginn der Übertragung der zweiten Signalfolge wird die dritte Timereinheit gestartet, die nach Ablauf eines Timerzyklus eine Aktion auslöst bzw. den zweiten Ereignisanwender zurücksetzt. Alternativ kann die Zeitdauer durch den ersten Ereignisgenerator überwacht werden, der eine Ereignismeldung auslöst, sobald sich die wieder eintreffende erste Signalfolge, die einen Wechsel der Übertragungsphase signalisiert, und die zweite Signalfolge überlagern.

Der Wechsel der Übertragungsphasen wird vorzugsweise von der Leseeinheit vorgegeben, die als Master konfiguriert ist. Die Zählereinheiten agieren hingegen als Slaves, die innerhalb Übertragungsphasen Daten zur Leseeinheit übertragen können, die ihnen von der Leseeinheit zugeordnet werden. Die Zählereinheiten oder Slaves überwachen daher die von der Leseeinheit übertragene Signalfolge, mittels der Daten und elektrische Energie zu den Zählereinheiten übertragen werden können. Vorzugsweise wird die Hüllkurve der ersten Signalfolge gebildet, innerhalb der Signallücken bzw. zweite Übertragungsphasen ermittelt werden, in denen Daten mit einer zweiten Signalfolge zur Leseeinheit übermittelt werden können. Diese zweite Signalfolge, die auf derselben Übertragungsleitung übertragen wird, wie die erste Signalfolge und zusammen mit dieser zum Eingang der Zählereinheit geführt wird, erschwert hingegen die Ermittlung der Hüllkurve und wird in der Zählereinheit für diesen Zweck vorzugsweise gefiltert und unterdrückt. Dies kann wiederum vorteilhaft mit Ereignisgeneratoren und Ereignisanwendern vollzogen werden, ohne Arbeitsleistung des Prozessors in Anspruch zu nehmen.

Das erfindungsgemässe Verfahren, die erfindungsgemässe Vorrichtung zur Datenübertragung sowie und die erfindungsgemässe Leseeinheit werden nachstehend in vorzugsweisen Ausgestaltungen beispielsweise beschrieben. Es zeigen:
- Fig. 1: eine erfindungsgemässe Vorrichtung zur Übertragung von Daten innerhalb wenigstens einer ersten und einer zweiten Übertragungsphase, die synchron oder asynchron aufeinander folgen, mit einer Leseeinheit L und einer Zählereinheit Z, die über eine Übertragungsleitung W kommunizieren;
- Fig. 2a: eine von der Leseeinheit L abgegebene erste Signalfolge SL und eine von der Zählereinheit Z abgegebene zweite Signalfolge SZ, die innerhalb der ersten und zweiten Übertragungsphase TP1, TP2 in der Vorrichtung bzw. auf der Übertragungsleitung W von Fig. 1 auftreten;
- Fig. 2b: Ereignisgeneratoren EG1 und EG2, mittels denen Änderungen der ersten Signalfolge SL bei den Übergängen zwischen den Übertragungsphasen TP1, TP2 detektierbar sind sowie ein erster Ereignisanwender EU1, mittels dessen die zweite Signalfolge SZ erzeugt werden kann;
- Fig. 3a: die Signalfolgen SL, SZ von Fig. 2a, wobei die innerhalb der zweiten Übertragungsphase TP2 nicht modulierte zweite Signalfolge SZ ein Datenbit "1" repräsentiert;
- Fig. 3b: die Ereignisgeneratoren EG1 und EG2 und der erste Ereignisanwender von Fig. 2a mit den im Diagramm von Fig. 3a auftretenden Signalen;
- Fig. 4a: die Signalfolgen SL, SZ von Fig. 2a, wobei die erste Signalfolge SL ein Gleichspannungssignal ist, dessen Potential bei den Übergängen zwischen den Übertragungsphasen TP1, TP2 umgeschaltet wird;
- Fig. 4b: die Ereignisgeneratoren EG1 und EG2 und der erste Ereignisanwender von Fig. 2a mit den im Diagramm von Fig. 4a auftretenden Signalen;
- Fig. 5: ein Flussdiagramm mit den einzelnen Verfahrensschritten, die bei der Durchführung des Verfahrens zur Datenübertragung zwischen der Leseeinheit L und der Zählereinheit Z von Fig. 1 durchgeführt werden; und
- Fig. 6: ein Diagramm mit einem ereignisgesteuerten Prozessablauf zur Datenübertragung auf der rechten Seite und dem Ablauf eines Hauptprozesses auf der linken Seite, der jeweils bei einem Wechsel der Übertragungsphasen TP1, TP2 bzw. TP2, TP1 unterbrochen wird.

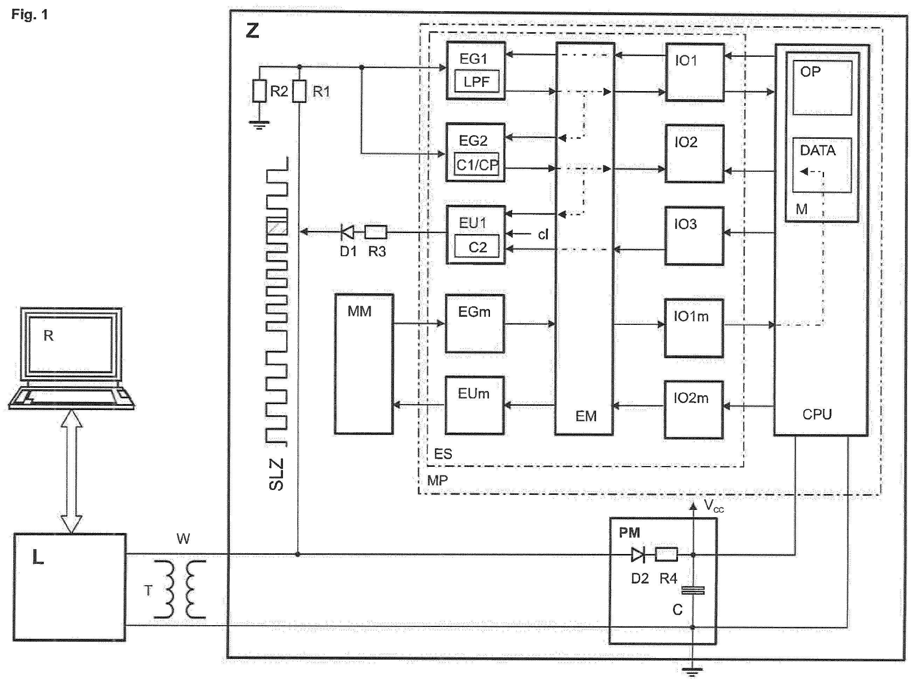

Die Fig. 1 zeigt eine erfindungsgemässe Vorrichtung zur Datenübertragung mit einer ersten Kommunikationseinheit L und einer zweiten Kommunikationseinheit Z, die über eine Übertragungsleitung W miteinander verbunden sind. Die Datenübertragung kann bidirektional oder unidirektional von der einen zur anderen Kommunikationseinheit L, Z bzw. Z, L erfolgen. Ferner kann eine synchrone oder asynchrone Übertragung von Daten erfolgen. Weiterhin kann eine geschaltete Gleichspannung übertragen werden, in die gegebenenfalls Datensignale eingeprägt sind. Ferner kann eine Wechselspannung übertragen werden, die gegebenenfalls entsprechend den zu übertragenden Daten moduliert ist.

Die Übertragungsleitung W kann durchgehende Leitungen aufweisen, so dass ein Gleichspannungspotential übertragbar ist.

Wie Fig. 1 zeigt, können die Kommunikationseinheiten L, Z hingegen auch mit je einer Übertragungsleitung verbunden werden, an deren Enden Kopplungsspulen vorgesehen sind. Die Kopplungsspulen können dabei Elemente eines Transformators T bilden oder wahlweise induktiv miteinander koppelbar sein, sodass die Kommunikationseinheiten L, Z bedarfsweise miteinander koppelbar sind, falls Daten übertragen werden sollen. Im vorliegenden Ausführungsbeispiel ist die zweite Kommunikationseinheit Z als Zählereinheit ausgebildet, mittels der z.B. der Verbrauch eines flüssigen oder gasförmigen Mediums, wie Gas oder Wasser, oder der Verbrauch von elektrischer oder thermischer Energie registrierbar ist. Dazu weist die Zählereinheit Z ein z.B. mit Sensoren verbundenes Messmodul MM auf, welches Messdaten DATA bildet, die in einer Speichereinheit M eines Mikroprozessors oder Mikrocontrollers MP abgespeichert werden. Mit der in diesem Ausführungsbeispiel als Leseeinheit ausgestalteten ersten Kommunikationseinheit L können diese Messdaten DATA in der Folge ausgelesen werden. Dazu wird ein Übertragungsprotokoll verwendet, gemäss dem die Messdaten DATA von der Zählereinheit Z zur Leseeinheit L übertragen werden. Von der Leseeinheit L werden die gesammelten Messdaten DATA z.B. zu einem zentralen Rechner R übertragen.

Zusätzlich kann das Übertragungsprotokoll auch die Übertragung von Daten von der Leseeinheit L zur Zählereinheit Z spezifizieren. Das Übertragungsprotokoll kann ferner vorsehen, dass Daten innerhalb einer Netzwerk-Topologie zwischen wenigstens einer Leseeinheit L und mehreren Zählereinheiten Z ausgetauscht werden können. Grundsätzlich ist es auch möglich, dass die Kommunikationseinheiten L, Z wahlweise eines von mehreren Übertragungsprotokollen anwenden.

Die Kommunikationseinheiten L, Z können ferner autonom von einer eigenen Stromversorgungseinheit gespeist oder über die Übertragungsleitung W mit Energie versorgt werden.

In der vorliegenden Ausgestaltung ist vorgesehen, dass die Zählereinheit Z von der Leseeinheit L durch eine Gleichspannung oder durch eine Wechselspannung mit Strom versorgt wird. Dazu ist ein Stromversorgungsmodul PM mit einer Diode D2 vorgesehen, die eine positive Gleichspannung oder positiv gerichtete Halbwellen eine Wechselspannung über einen Widerstand R4 an einen Ladekondensator C angelegt, der in der Folge die Zählereinheit Z mit Strom versorgt.

Die Zählereinheit Z umfasst eine zentrale Prozessoreinheit CPU, die mit der genannten Speichereinheit M verbunden ist, in der ein Betriebsprogramm OP und die Messdaten DATA abgelegt sind. Für die Kommunikation mit der Leseeinheit L nutzt die CPU die Dienste eines Ereignissystems ES, welches einen oder mehrere Ereignisgeneratoren EG1 und vorzugsweise einen oder mehrere Ereignisanwender EU1, EU2 aufweist, die vorzugsweise über einen Eventmanager EM miteinander kommunizieren. In dieser vorzugsweisen Ausgestaltung sind ferner Eingangs und Ausgangseinheiten IO1, IO2, IO3 vorgesehen, die ebenfalls als Ereignisgeneratoren und/oder als Ereignisanwender agieren können.

Die Ereignisgeneratoren überwachen generell Prozesse und generieren Ereignismeldungen für bestimmte Ereignisse, die innerhalb der Prozesse auftreten. Die Ereignisanwender lösen Aktionen aus, sobald ihnen ein Ereignis gemeldet wird. Ereignisse können den Ereignisanwendern auch indirekt gemeldet werden. Z.B. erzeugt ein Ereignisgenerator eine Ereignismeldung, welche zur CPU übertragen wird, die in der Folge eine zur Ereignismeldung korrespondierende Instruktion an einen Ereignisanwender sendet. Die vom Ereignisgenerator erzeugte Ereignismeldung selbst kann ebenfalls über einen Ereignisanwender, nämlich eine der I/O- Einheiten IO1, IO2, IO3 der CPU gemeldet werden.

Das Ereignissystem ES stellt der CPU somit Dienste zur Verfügung und entlastet die CPU von Aufgaben bei der Behandlung von Prozessen, die kontinuierlich ablaufen können und erhebliche Ressourcen der CPU absorbieren würden.

Das Ereignissystem ES interagiert somit mit dem kontinuierlichen Datenübertragungsprozess und ermittelt relevante Informationen oder Ereignisse, die der CPU gemeldet oder im Ereignissystem ES direkt weiterverarbeitet werden.

Die interessierenden Vorgänge in den vom Ereignissystem ES überwachten Prozessen, vorliegend im Prozess der Datenübertragung, sind daher zu definieren. Ferner sind die Ereignisgeneratoren entsprechend auszugestalten, damit die Ereignisse detektiert werden können.

Ebenso sind die Ereignisanwender entsprechend auszugestalten, damit sie die entsprechenden Aktionen auslösen können, die vorzugsweise ebenfalls im entsprechenden Protokoll für die Datenübertragung spezifiziert sind.

In der vorliegenden Ausgestaltung ist ein erster Ereignisgenerator EG1 als steuerbares Tiefpassfilter LPF ausgebildet, welches unterhalb einer ersten oder einer zweiten Grenzfrequenz liegende Signale passieren lässt. Die Steuerung des Tiefpassfilters LPF erfolgt in Abhängigkeit der vorliegenden Übertragungsphase, d.h. der ersten Übertragungsphase TP1, bei der Signale von der Leseeinheit l zur Zählereinheit Z übertragen werden, oder der wenigstens einen zweiten Übertragungsphase TP2, bei der Signale von der Zählereinheit Z zur Leseeinheit L übertragen werden.

Ferner ist ein zweiter Ereignisgenerator EG2 vorgesehen, mittels dessen die Übergänge zwischen den beiden Übertragungsphasen TP1, TP2 ermittelt werden. Da der Wechsel der Übertragungsphasen TP1, TP2 von der Leseeinheit L vorgegeben wird, wird vorzugsweise die Hüllkurve der ersten Signalfolge SL ermittelt, die von der Leseeinheit L zur Zählereinheit Z übertragen wird. Zur Ermittlung der Hüllkurve sind Im zweiten Ereignisgenerator EG2 eine erste Timereinheit C1 und ein Komparator CP vorgesehen, die nachstehend näher erläutert werden.

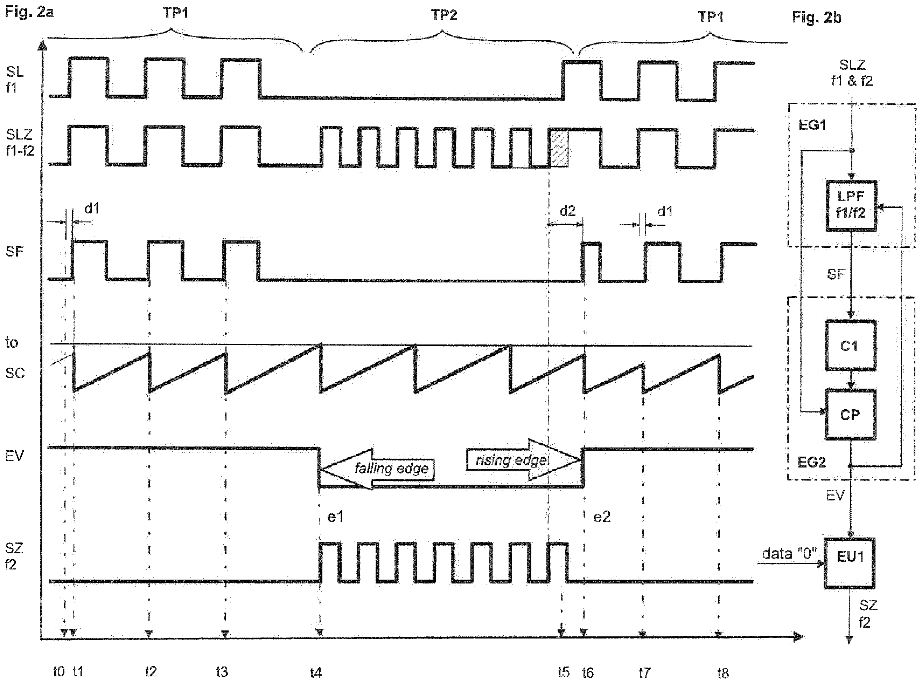

Anhand der ermittelten Übergänge der Übertragungsphasen TP1, TP2 bzw. der Flanken der Hüllkurve der ersten Signalfolge SL werden das im ersten Ereignisgenerator EG1 vorgesehene Tiefpassfilter LPF sowie ein erster Ereignisanwender EU1 gesteuert. Vom ersten Ereignisanwender EU1, in dem vorzugsweise eine zweite Timereinheit C2 angeordnet ist, wird nach Beginn der zweiten Übertragungsphase TP2 über einen Widerstand R3 und eine Diode D1 eine zweite Signalfolge an die Übertragungsleitung W angelegt und zur Leseeinheit L übertragen. In Fig. 2 ist illustriert, dass sich beim Neubeginn der ersten Übertragungsphase TP1 die erste und die zweite Signalfolge überlagern, wodurch die Detektion des Übergangs von der ersten zur zweiten Übertragungsphase TP1-TP2 erschwert wird. Für die Ermittlung der Hüllkurve der ersten Signalfolge SL wird die zweite Signalfolge SZ daher vorzugsweise ausgefiltert.

Wie erwähnt, überwacht der Ereignisgenerator EG1 den Prozess der Datenübertragung und entbindet die CPU oder einen entsprechenden Signalprozessor von dieser Aufgabe. Fig. 1 zeigt, dass dazu die auf der Übertragungsleitung W auftretende erste Signalfolge SL der Leseeinheit L und zwangsläufig auch die zweite Signalfolge SZ der Zählereinheit Z über einen Spannungsteiler R1/R2 zum Eingang des ersten Ereignisgenerators EG1 geführt wird.

Für ein auftretendes Ereignis erzeugt der Ereignisgenerator EG1 eine Ereignismeldung e1, e2, die über den Eventmanager EM und die I/O-Einheit IO1 vorzugsweise einerseits zur CPU und andererseits zu einem Eingang des ersten Ereignisanwenders EU1 geführt wird.

Die Ereignismeldung ep wird z.B. zu einem Interrupt-Eingang der CPU geführt, sodass der in der CPU ablaufende Hauptprozess unterbrochen und nach einem Programmsprung eine Interruptroutine oder Subroutine ausgeführt wird, durch die ein Ausgangssignal ausgelöst wird, das dem ersten Ereignisanwender EU1 über die I/O-Einheit IO2 zugeführt wird. Z.B. können dem Ereignisanwender EU1 zuvor gespeicherte Messdaten DATA zugeführt werden, wonach dieser über den Widerstand R3 und die Diode D1 ein entsprechendes Ausgangssignal an die Übertragungsleitung W angelegt.

Die Architektur eines Mikroprozessors, insbesondere die Prinzipien der I/O Hardware und Software, insbesondere Interruptvorgänge, sind in Andrew S. Tanenbaum, Modern Operating Systems, 2nd Edition, 2001 New Jersey, ab Seite 269 beschrieben.

Vor der exemplarischen Beschreibung von Vorgängen zur Übertragung von Daten zwischen der Leseeinheit L und der Zählereinheit Z wird darauf hingewiesen, dass die Dienste des Ereignissystems auch für weitere Aufgaben genutzt werden können. Dazu ist exemplarisch gezeigt, dass das Messmodul MM ebenfalls über einen Ereignisgenerator EGm und einen Ereignisanwender EUm sowie entsprechende I/O-Einheiten IO1m, IO2m mit der CPU verbunden ist. Mittels des Ereignisgenerators EGm kann ein kontinuierlich ablaufender Messprozess überwacht werden, während über den Ereignisanwender EUm eine Steuerung dieses Messprozesses möglich ist.

Die in Fig. 1 gezeigten Module des Ereignissystems ES können beliebig gewählt und konfiguriert werden. Dabei können bedarfsweise Filterstufen, AD-Wandler, DA-Wandler, Timereinheiten, Frequenzgeneratoren, DMA-(direct memory access) Einheiten, etc. als Ereignisgeneratoren EG und/oder als Ereignisanwender EU eingesetzt werden. Das Ereignissystem ES kann dabei unabhängig vom Mikroprozessor MP aufgebaut sein. Vorzugsweise wird jedoch ein Mikroprozessor MP gewählt, welcher Ereignismodule oder das gesamte Ereignissystem ES bereits umfasst, mittels dessen das erfindungsgemässe Verfahren durchführbar ist.

Fig. 2a zeigt, dass die Übertragung von Daten und Signalen zwischen der Leseeinheit L und der Zählereinheit Z in zwei getrennten Übertragungsphasen TP1, TP2 erfolgt, die zyklisch und synchron oder asynchron verlaufen. Während den ersten Übertragungsphasen TP1 wird jeweils eine erste Signalfolge SL mit einer Frequenz von z.B. f1 = 30 kHz von der Leseeinheit L zur Zählereinheit Z übertragen. Während den zweiten Übertragungsphasen TP2 wird jeweils eine zweite Signalfolge SZ von der Zählereinheit Z zur Leseeinheit L übertragen, die in Abhängigkeit der zu übertragenden Daten moduliert ist. Für ein Datenbit "1" erfolgt keine Modulation der zweiten Signalfolge SZ. Für die Übertragung eines Datenbits "0" hingegen wird die zweite Signalfolge mit einem Rechtecksignal moduliert, das z.B. eine Frequenz von f2 = 42 kHz aufweist. Beide Signalfolgen werden an die Übertragungsleitung W angelegt, auf der somit eine kombinierte Signalfolge SLZ auftritt, die dem ersten Ereignisgenerator EG1 zugeführt wird. Es ist gezeigt, dass sich die erste und die zweite Signalfolge SL und SZ jeweils beim Neubeginn der ersten Übertragungsphasen TP1 überdecken.

Resistive, kapazitive und induktive Einflüsse innerhalb der Verbindung zwischen der Leseeinheit L und der Zählereinheit Z führen zu Veränderungen der ersten Signalfolge SL. Ferner können hochfrequente Störsignale auf der Übertragungsleitung W auftreten. Durch das im ersten Ereignisgenerator EG1 vorgesehene Tiefpassfilter LPF werden solche Störungen während der ersten Übertragungsphase TP1 unterdrückt. Z.B. werden Signale mit einer Impulsbreite von weniger als 2 µs gesperrt. Nur Signale, insbesondere die erste Signalfolge, deren Pulsbreiten grösser als 2 µs sind, werden vom ersten Ereignisgenerator EG1 zum zweiten Ereignisgenerator EG2 durchgelassen. Die Signale werden innerhalb der ersten Übertragungsphase TP1 daher mit einer Verzögerung von d1 = 2 µs weitergeleitet.

Für die Verarbeitung des kombinierten Signals SLZ in der Zählereinheit Z, insbesondere zur Ermittlung der von der Leseeinheit L bestimmten Übertragungsphasen TP1, TP2, die entsprechend der Hüllkurve EV der ersten Signalfolge SL verlaufen, wird die erste Signalfolge SL ausgewertet. Damit diese Auswertung erfolgen kann, wird zuerst die eine höhere Frequenz f2 aufweisende zweite Signalfolge SZ gefiltert. Die Grenzfrequenz des Tiefpassfilters LPF im ersten Ereignisgenerator EG1 wird entsprechend gesenkt, sodass die Frequenz f2 der zweiten Signalfolge SZ ausserhalb des Durchlassbereichs des Tiefpassfilters LPF liegt. Es wird vorgesehen, dass Pulse mit einer Breite von weniger als 12 µs vom Tiefpassfilter LPF gesperrt werden. Die Pulse der zweiten Signalfolge SZ weisen bei der Frequenz f2 = 42 kHz eine Pulsbreite von etwa 11 us auf und werden daher gesperrt. Die erste Signalfolge SL wird in der zweiten Übertragungsphase TP2 daher mit einer Verzögerung von d2 = 12 µs weitergeleitet.

Zur Durchführung des Verfahrens sind mittels des zweiten Ereignisgenerators EG2 innerhalb der Zählereinheit Z die Zeitpunkte zu ermitteln, zu denen die zweite Übertragungsphase TP2 beginnt und die zweite Signalfolge SZ übertragen und das Tiefpassfilter LPF umgestellt werden kann sowie zu denen die zweite Übertragungsphase TP2 endet und die Übertragung der zweiten Signalfolge SZ gestoppt und das Tiefpassfilter LPF zurückgesetzt werden muss.

Diese Zeitpunkte können vorteilhaft aus der Hüllkurve EV der ersten Signalfolge abgelesen werden. Zur Ermittlung der Hüllkurve EV der ersten Signalfolge SL ist im zweiten Ereignisgenerator EG2 eine erste Timereinheit C1 vorgesehen, die bei jeder ansteigenden Flanke des vom ersten Ereignisgenerator EG1 abgegebenen Signals zurückgesetzt wird und sonst zyklisch jeweils während einer Periodendauer Tc1 bis zu einem Timeout to hoch läuft und bei Erreichen des Timeout zurückgesetzt wird. Die Periodendauer Tc1 ist dabei grösser als die Periodendauer der ersten Signalfolge SL gewählt, sodass diese sicher erfasst werden kann.

Fig. 2a zeigt den Verlauf des Timersignals SC, das zu den Zeitpunkten t1, t2 und t3 jeweils vor Erreichen des Timeouts to durch das Auftreten einer ansteigenden Flanke der ersten Signalfolge SL zurückgesetzt wird. Gleichzeitig wird der logische Zustand "1" des Signals auf der Übertragungsleitung W übernommen. Nachdem die Übertragung der ersten Signalfolge SL vor dem Zeitpunkt t4 beendet wurde, läuft das Timersignal SC zum Zeitpunkt t4 in das Timeout to hoch und wird dadurch zurückgesetzt, wobei der aktuelle logische Zustand "0" des Signals auf der Übertragungsleitung W übernommen wird. Aufgrund dieses Übergangs von logisch "1" auf "0" wird eine abfallende Flanke der Hüllkurve EV der ersten Signalfolge SL erkannt (siehe den Pfeil "falling edge").

Das Timersignal SC verläuft nun so lange weiter zyklisch bis ins Time-out to bis am Eingang der Timereinheit C1 wieder eine ansteigende Flanke des gefilterten Signals SF erscheint, die anzeigt, dass wieder eine erste Übertragungsphase TP1 begonnen hat und von der Leseeinheit L eine weitere erste Signalfolge SL übertragen wurde. Wiederum wird der logische Zustand des Signals auf der Übertragungsleitung W abgetastet und übernommen. Der zu diesem Zeitpunkt t6 vorliegende logisch Zustand "1" zeigt, dass eine ansteigende Flanke der Hüllkurve EV der ersten Signalfolge SL erfolgt ist (siehe den Pfeil "rising edge").

Diese Zustandsänderungen "falling edge" und "rising edge" der Hüllkurve EV der ersten Signalfolge SL werden im Ereignissystem ES von Fig. 1 als Ereignisse e1, e2 erfasst und zur Steuerung des ersten Ereignisgenerators EG1, insbesondere des Tiefpassfilters LPF und zur Steuerung des ersten Ereignisanwenders EU1 verwendet.

Das Ereignis e1 (falling edge / abfallende Flanke) veranlasst die Abgabe der zweiten Signalfolge SZ durch den ersten Ereignisanwender EU1 und die Umschaltung des Tiefpassfilters LPF auf eine tiefere Grenzfrequenz. Fig. 2a zeigt exemplarisch, dass mit der zweiten Signalfolge SZ eine logische "0" übertragen wird, für die die zweite Signalfolge mit einem Rechtecksignal der Frequenz f2 = 42 kHz moduliert wird.

Gezeigt ist, dass zum Zeitpunkt t5 wieder eine ansteigende Flanke der ersten Signalfolge SL erscheint, die an einen Puls der zweiten Signalfolge anschliesst, weshalb eine Pulsbreite von mehr als 12 µs resultiert, die vom Tiefpassfilter LPF mit einer Verzögerung d2 weitergegeben wird, weshalb wieder eine ansteigende Flanke am Eingang der Timereinheit C1 resultiert, wodurch dieser zurückgesetzt und der logische Zustand "1" der kombinierten Signalfolge SLZ auf der Übertragungsleitung W für die Hüllkurve EV übernommen wird.

Aufgrund des Wechsel des Zustands der Hüllkurve EV von logisch "0" auf "1" wird zum Zeitpunkt t6 das Auftreten einer ansteigenden Flanke (Pfeil "rising edge") registriert. Die Übertragung der zweiten Signalfolge SZ wird eingestellt und das Tiefpassfilter LPF wird auf die höhere Grenzfrequenz zurückgesetzt, die es erlaubt, Störungen zu eliminieren, Flanken der ersten Signalfolge SL jedoch sicher zu erkennen.

Zu den Zeitpunkten t7 und t8 wird die Timereinheit C1 bei Auftreten einer ansteigenden Flanke der ersten Signalfolge wieder zurückgesetzt.

Das Signal SF am Ausgang des Tiefpassfilters LPF zeigt, dass durch den Wechsel der Grenzfrequenz zu Beginn der ersten Übertragungsphase TP1 eine Signalverzögerung d2 = 12 µs und anschliessend eine Verzögerung von d1 = 2 µs erfolgt.

Fig. 2b zeigt die Ereignisgeneratoren EG1 und EG2 von Fig. 1, mittels denen Änderungen der ersten Signalfolge SL bei den Übergängen zwischen den Übertragungsphasen TP1, TP2 detektierbar sind. Die kombinierte Signalfolge SLZ wird dem Eingang des Ereignisgenerators EG1 zugeführt und darin im Tiefpassfilter LPF gefiltert. Das Ausgangssignal SF des ersten Ereignisgenerators EG1, dass von der zweiten Signalfolge SZ befreit ist, wird dem Eingang des zweiten Ereignisgenerators EG2 bzw. der ersten Timereinheit C1 zugeführt, die den nachgeschalteten Komparator CP triggert. Der Komparator CP tastet den Zustand des Signals auf der Übertragungsleitung W ab und stellt fest, ob eine Flanke der Hüllkurve EV und somit ein Übergang zwischen den Übertragungsphasen TP1, TP2 und somit aufgetreten ist.

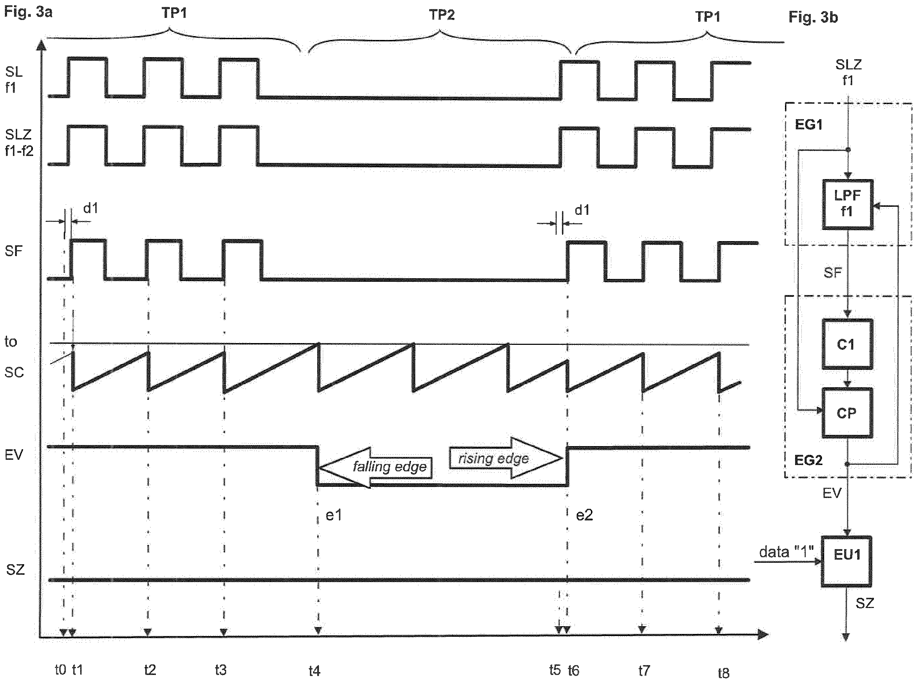

Fig. 3a zeigt die Signalfolgen SL, SZ und SLZ von Fig. 2a, wobei zweite Signalfolge SZ ein Datenbit "1" repräsentiert und nicht moduliert ist. Die kombinierte Signalfolge SLZ ist daher identisch zur ersten Signalfolge SL, weshalb die Grenzfrequenz des Tiefpassfilters LPF nicht heruntergesetzt werden muss. D.h., die nicht modulierte zweite Signalfolge SZ stört die Detektion der Hüllkurve EV nicht und muss nicht eliminiert werden. Da das Tiefpassfilter LPF nicht umgestellt wird, wird das gefilterte Signal SF mit der Verzögerung von d1 = 2 µs weitergeleitet.

Die ansteigende Flanke des zum Zeitpunkt t5 auftretenden ersten Pulses der ersten Signalfolge SL wird daher lediglich mit der Verzögerung d1 = 2 µs weitergeleitet, wonach die ansteigende Flanke (siehe Pfeil: rising edge) der Hüllkurve EV zum Zeitpunkt t6 erkannt wird.

Mit dem der abfallenden Flanke der Hüllkurve EV und der dadurch ausgelösten Ereignismeldung e1 wird somit die Abgabe der nicht modulierten zweiten Signalfolge SZ ausgelöst, ohne das Tiefpassfilter LPF umzuschalten. Mit der ansteigenden Flanke der Hüllkurve EV und der Ereignismeldung e2 wird daher ebenfalls nur die Übertragung der zweiten Signalfolge SZ beendet. Die Umschaltung des Tiefpassfilters LPF erfolgt daher vorzugsweise unter Berücksichtigung der zu übertragenden Daten.

Fig. 3b zeigt die Ereignisgeneratoren EG1 und EG2 von Fig. 2a, mittels denen Änderungen der ersten Signalfolge SL bei den Übergängen zwischen den Übertragungsphasen TP1, TP2 detektierbar sind. Zwischen den Modulen sind wiederum die auftretenden Signale SLZ, SF, EV, SZ eingetragen, die im Diagramm von Fig. 3a gezeigt sind.

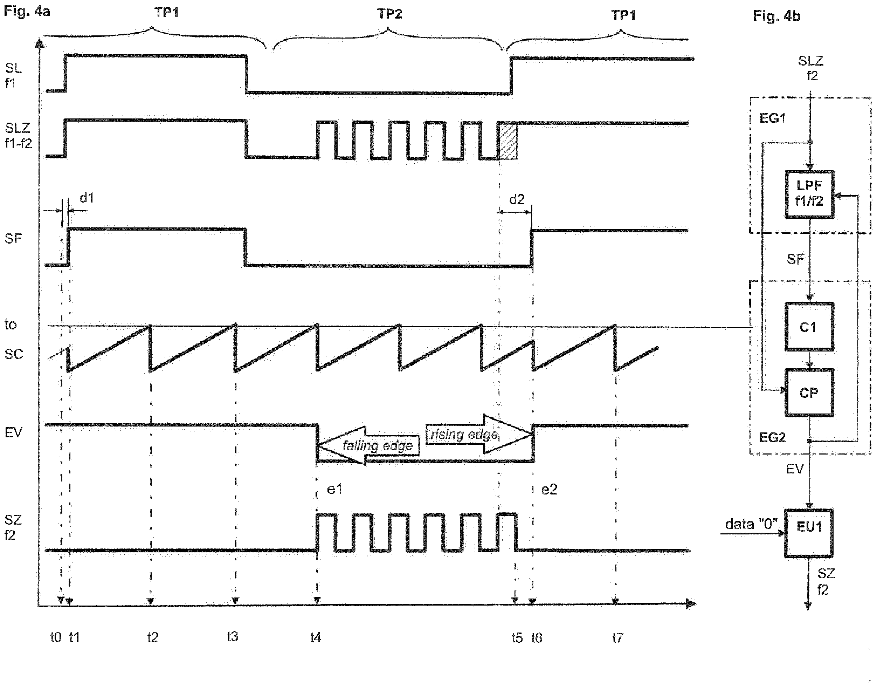

Fig. 4a zeigt die Signalfolgen SL, SZ und SLZ von Fig. 2a, wobei die erste Signalfolge SL ein Gleichspannungssignal ist, dessen Potential bei den Übergängen zwischen den Übertragungsphasen TP1, TP2 umgeschaltet wird. Zum Zeitpunkt t1 wird das Timersignal SC durch das Auftreten der ansteigenden Flanke der ersten Signalfolge SL zum Zeitpunkt t0 nach einer Verzögerung von 2 µs zurückgesetzt. Anschliessend tritt bis zum Zeitpunkt t6 keine ansteigende Flanke der ersten Signalfolge SL mehr auf, weshalb das Timersignal SC nun jeweils bis zum Timeout to hoch läuft, wonach jeweils das Timersignal SC zurückgesetzt und der aktuelle Wert der ersten Signalfolge SL übernommen wird. Zum Zeitpunkt t4 wird der Wert logisch "0" übernommen und das Eintreten der zweiten Übertragungsphase TP2 erkannt. Mit der entsprechenden Ereignismeldung e1 wird die Übertragung der zweiten Signalfolge SZ gestartet und das Tiefpassfilter LPF auf den tieferen Grenzwert umgestellt, der sicherstellt, dass die zweite Signalfolge SZ im Ausgangssignal SF des Tiefpassfilters LPF nicht erscheint. Zum Zeitpunkt t5 überlagern sich die neu erscheinende erste Signalfolge SL und die zweite Signalfolge SZ, weshalb nach der Verzögerung d2 eine ansteigende Flanke am Ausgang des Tiefpassfilters LPF erscheint. Dadurch wird die Timereinheit C1 zurückgesetzt, eine logisch "1" auf der Übertragungsleitung W abgetastet und zum Zeitpunkt t6 eine ansteigende Flanke der Hüllkurve EV erkannt wird. Nach Erkennen des Neubeginns der ersten Übertragungsphase TP1 wird die Abgabe der zweiten Signalfolge SZ beendet und die Grenzfrequenz des Tiefpassfilters LPF wieder geändert.

Fig. 4b zeigt die Ereignisgeneratoren EG1 und EG2 von Fig. 2a, mittels denen Änderungen der ersten Signalfolge SL bei den Übergängen zwischen den Übertragungsphasen TP1, TP2 detektierbar sind. Es ist zu beachten, dass nur bei der Übertragung einer logisch "0" und der entsprechenden Modulation der zweiten Signalfolge SZ eine Umschaltung des Tiefpassfilters LPF auf die tiefere Grenzfrequenz erforderlich ist.

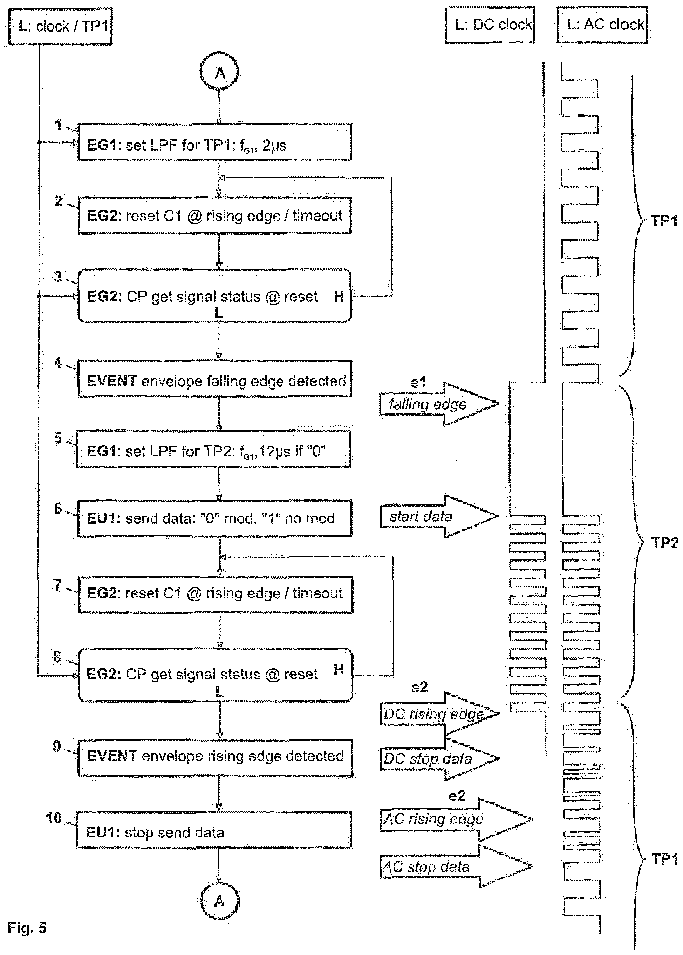

Fig. 5 zeigt ein Flussdiagramm mit den bereits beschriebenen Verfahrensschritten, die in der Vorrichtung gemäss Fig. 1 beim Wechsel zwischen den Übertragungsphasen TP1, TP2 vollzogen werden.

Während den ersten Übertragungsphasen TP1 wird von der Leseeinheit L die erste Signalfolge SL entweder als Gleichspannungssignal (DC) oder als Wechselspannungssignal (AC) übertragen. Während der zweiten Übertragungsphase TP2 wird von der Zählereinheit Z mit der Abgabe der modulierten zweiten Signalfolge SZ eine logisch "0" zur Leseeinheit L übertragen. Bei beiden Fällen AC und DC ist somit eine Umschaltung des Tiefpassfilters LPF für die zweite Übertragungsphase TP2 zur Unterdrückung der zweiten Signalfolge SZ erforderlich, damit die Hüllkurve EV der ersten Signalfolge SL ermittelt werden kann.

Mit Verfahrensschritt 1 wird die Grenzfrequenz des Tiefpassfilters LPF im ersten Ereignisgenerator EG1 auf den höheren Wert von z.B. 250 kHz gesetzt, der es erlaubt, Störungen auf der Übertragungsleitung W zu unterdrücken.

Mit Verfahrensschritt 2 wird im zweiten Ereignisgenerator EG2 die Timereinheit C1 jeweils beim Auftreten einer ansteigenden Flanke oder beim Erreichen des Timeout zurückgesetzt.

Mit Verfahrensschritt 3 wird im zweiten Ereignisgenerator EG2 bei jedem Zurücksetzen der Timereinheit C1 der Signalstatus auf der Übertragungsleitung W abgetastet, um eine Statusänderung zu erkennen.

Mit Verfahrensschritt 4 wird das Ereignis des Wechsels der Übertragungsphase TP1-TP2 bzw. der Beginn der zweiten Übertragungsphase TP2 erkannt und es wird eine entsprechende Ereignismeldung e1 übermittelt.

Mit Verfahrensschritt 5 wird die Grenzfrequenz des Tiefpassfilters LPF im ersten Ereignisgenerator EG1 entsprechend der Frequenz der zweiten Signalfolge SZ auf einen tieferen Wert von z.B. 35 kHz gesetzt, der es erlaubt, die zweite Signalfolge SZ mit der Frequenz von 42 kHz zu unterdrücken, die bei der Ermittlung der Hüllkurve EV stören würde. Diese Umstellung erfolgt vorzugsweise nur dann, wenn die zweite Signalfolge SZ für die Übertragung einer logisch "0" moduliert wird.

Mit Verfahrensschritt 6 überträgt der erste Ereignisanwender EU1 die zweite Signalfolge SZ.

Mit Verfahrensschritt 7 wird im zweiten Ereignisgenerator EG2 die Timereinheit C1 jeweils beim Auftreten einer ansteigenden Flanke oder beim Erreichen des Timeout zurückgesetzt.

Mit Verfahrensschritt 8 wird im zweiten Ereignisgenerator EG2 bei jedem Zurücksetzen der Timereinheit C1 der Signalstatus auf der Übertragungsleitung W abgetastet, um eine Statusänderung zu erkennen.

Mit Verfahrensschritt 9 wird das Ereignis des Wechsels der Übertragungsphase TP1-TP2 erkannt und es wird eine entsprechende Ereignismeldung e2 übermittelt.

Mit Verfahrensschritt 10 wird im ersten Ereignisanwender EU1 die Übertragung der zweiten Signalfolge SZ angehalten. Es ist gezeigt, dass die ansteigende Flanke der Hüllkurve EV früher erkannt wird, wenn die erste Signalfolge SL ein Gleichspannungssignal ist.

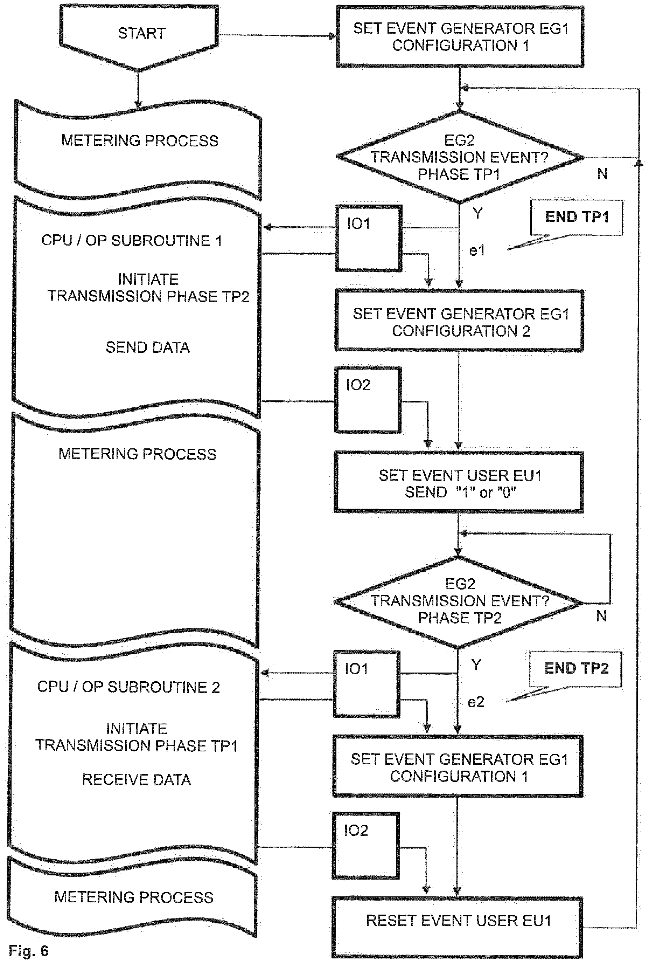

Fig. 6 zeigt ein Diagramm mit einem ereignisgesteuerten Prozessablauf zur Datenübertragung auf der rechten Seite und den Ablauf eines Hauptprozesses auf der linken Seite, der jeweils bei einem Wechsel der Übertragungsphasen TP1, TP2 bzw. TP2, TP1 unterbrochen wird.

Die CPU bearbeitet in diesem Ausführungsbeispiel einen Messprozess oder Metering-Prozess, wobei ein entsprechendes Programm abgearbeitet wird. Dieser Programmablauf wird punktuell unterbrochen, falls seitens des ereignisgesteuerten Prozessablaufs Ereignismeldungen e1, e2 eintreffen, durch die jeweils ein Sprung zu einer Subroutine 1 bzw. 2 ausgelöst wird. Mittels der Subroutinen 1 bzw. 2 wird das Ereignissystem ES jeweils für die nächste Übertragungsphase TP1 bzw. TP2 konfiguriert, falls dies notwendig ist. Ferner werden gegebenenfalls Daten empfangen oder Daten, insbesondere Messdaten bzw. Zählerdaten, gesendet.

Bei Inbetriebnahme der Zählereinheit Z werden der Metering Prozess und der Datenübertragungsprozess bzw. das Ereignissystem ES initialisiert. Dazu wird der Ereignisgenerator EG1 für die Überwachung der ersten Signalfolge SL während der ersten Übertragungsphase TP1 konfiguriert. Vom ersten Ereignisgenerator EG1 wird die erste Signalfolge SL gefiltert und zum zweiten Ereignisgenerator EG2 übertragen, der einen Wechsel der Übertragungsphase TP1/TP2 detektiert und eine Ereignismeldung e1 generiert.

Nach der Detektion des Ereignisses des Abschlusses der ersten Übertragungsphase TP1 wird eine erste Ereignismeldung e1 über die erste I/O-Einheit IO1 an die CPU übertragen, welche über dieselbe I/O-Einheit IO1 Konfigurationsdaten an den ersten Ereignisgenerator EG1 sendet, um diesen für die zweite Übertragungsphase TP2 zu konfigurieren. Über die zweite I/O-Einheit IO2 sendet die CPU ferner Daten zum ersten Ereignisanwender EU1, die während der zweiten Übertragungsphase TP2 zur Leseeinheit L übertragen werden.

Der Ereignisgenerator EG1 filtert nun in seiner zweiten Konfiguration wiederum die auf der Übertragungsleitung W auftretende Kombination SLZ der ersten und zweiten Signalfolgen SL und SZ und leitet diese an den zweiten Ereignisgenerator EG2 weiter, der eine zweite Ereignismeldung e2 erzeugt, sobald der Abschluss der zweiten Übertragungsphase TP2 festgestellt wird. Die zweite Ereignismeldung e2 wird der CPU wiederum über die erste I/O-Einheit IO1 übertragen, welche über dieselbe I/O-Einheit IO1 Konfigurationsdaten an den ersten Ereignisgenerator EG1 sendet, um diesen wieder für die erste Übertragungsphase TP1 zu konfigurieren. Über die zweite I/O-Einheit IO2 wird der erste Ereignisanwender EU1 zurückgesetzt und die Übertragung der zweiten Signalfolge SZ beendet.

Mittels des Ereignissystems ES gelingt es somit, die Datenübertragung zu steuern, ohne den Mikroprozessor MP wesentlich zu belasten. Mittels des Ereignissystems können jedoch auch komplexere Übertragungsvorgänge behandelt werden. Z.B. können mittels Ereignisgeneratoren EG von der Leseeinheit L übertragene Daten detektiert werden.

Mit entsprechender Ausgestaltung der Ereignismodule des Ereignissystems ES können Daten somit gestützt auf beliebige Übertragungsprotokolle bidirektional oder unidirektional, synchron oder asynchron, zwischen den Kommunikationseinheiten L und Z übertragen werden.

## Patentansprüche

1. Verfahren zur Übertragung von Datensignalen, gemäss einem angewendeten Übertragungsprotokoll innerhalb wenigstens einer ersten und einer zweiten Übertragungsphase (TP1, TP2), die synchron oder asynchron aufeinander folgen, zwischen einer ersten Kommunikationseinheit (L) und wenigstens einer zweiten Kommunikationseinheit (Z), die eine zentrale Prozessoreinheit (CPU)und eine Speichereinheit (M), in der ein Betriebsprogramm (OP) abgelegt ist, umfasst, **dadurch gekennzeichnet, dass** die zweite Kommunikationseinheit (Z) wenigstens einen ersten Ereignisgenerator (EG1) umfasst, der über eine Übertragungsleitung (W) zwischen den beiden Kommunikationseinheiten (L, Z) übertragene Signalfolgen (SL, SLZ) unabhängig von der zentralen Prozessoreinheit (CPU) überwacht und für Ereignisse während der Datenübertragung, die gemäss dem angewendeten Übertragungsprotokoll auftreten, Ereignismeldungen (e1, e2) erzeugt, die zur zentralen Prozessoreinheit (CPU) und/oder zu wenigstens einem ersten Ereignisanwender (EU1) übertragen werden.

2. Verfahren nach Anspruch 1, **dadurch gekennzeichnet, dass** während der ersten Übertragungsphase (TP1) eine erste Signalfolge (SL) von der ersten zur zweiten Kommunikationseinheit (L; Z) und während der zweiten Übertragungsphase (TP2) eine zweite Signalfolge (SZ) von der zweiten zur ersten Kommunikationseinheit (Z; L) übertragen wird, die in der zweiten Kommunikationseinheit (Z) von der zentralen Prozessoreinheit (CPU) oder dem ersten Ereignisanwender (EU1) erzeugt wird.

3. Verfahren nach Anspruch 2, **dadurch gekennzeichnet, dass** zur Ermittlung der Wechsel der Übertragungsphasen (TP1, TP2) die erste Signalfolge (SL) überwacht und die Flanken der korrespondierenden Hüllkurve (EV) ermittelt und dazu korrespondierende erste und zweite Ereignismeldungen (e1, e2) gebildet werden.

4. Verfahren nach Anspruch 3, **dadurch gekennzeichnet, dass** der wenigstens eine erste Ereignisgenerator (EG1) ein steuerbares Filter (LPF) umfasst, das für jede Übertragungsphase (TP1, TP2) bedarfsweise konfiguriert wird und das während jeder Übertragungsphase (TP1, TP2) die auf der Übertragungsleitung (W) auftretenden Signalfolgen (SL, SZ) filtert und ein gefiltertes Signal (SF) bildet, das von Störungen und von der zweiten Signalfolge (SZ) befreit ist.

5. Verfahren nach Anspruch 3 oder 4, **dadurch gekennzeichnet, dass** ein zweiter Ereignisgenerator (EG2) vorgesehen ist, der die auf der Übertragungsleitung (W) auftretenden Signalfolgen (SL, SZ) oder das gefilterte Signal (SF) überwacht und Signalflanken ermittelt, die einen Wechsel der Übertragungsphase (TP1, TP2) signalisieren.

6. Verfahren nach Anspruch 5, **dadurch gekennzeichnet, dass** der zweite Ereignisgenerator (EG2) eine erste Timereinheit (C1) umfasst, der das gefilterte Signal (SF) zugeführt wird und die beim Auftreten einer ansteigenden Flanke des Eingangssignals (SF) oder bei Erreichen eines Timeouts jeweils zurückgesetzt wird, wobei für jedes Zurücksetzen der Timereinheit (C1) der Zustand der Signalfolgen (SL, SLZ) auf der Übertragungsleitung (W) oder das gefilterte Signal (SF) abgetastet, eine Zustandsänderung ermittelt und die dazu korrespondierende erste oder zweite Ereignismeldung (e1, e2) gebildet wird.

7. Verfahren nach einem der Ansprüche 3-6, **dadurch gekennzeichnet, dass** der erste Ereignisanwender (EU1) mittels der ersten Ereignismeldung (e1) gestartet wird und die zweite Signalfolge (SZ) erzeugt, bis er mittels der zweiten Ereignismeldung (e2) angehalten wird, und/oder dass die Grenzfrequenz des Tiefpassfilters (LPF) im ersten Ereignisgenerator (EG1) nach Abschluss der ersten Übertragungsphase (TP1) mittels der ersten Ereignismeldung (e1) gesenkt und nach Abschluss der zweiten Übertragungsphase (TP2) mittels der zweiten Ereignismeldung (e2) erhöht wird, so dass die Grenzfrequenz des Tiefpassfilters (TPF) innerhalb der zweiten Übertragungsphase (TP2) unterhalb der Frequenz der zweiten Signalfolge (SZ) liegt und diese gesperrt werden kann.

8. Verfahren nach einem der Ansprüche 1-7, **dadurch gekennzeichnet, dass** wenigstens ein zweiter Ereignisanwender (IO1) als Ein-/Ausgabeeinheit konfiguriert ist und Ereignismeldungen (e1, e2) vorzugsweise über einen Interrupt-Eingang zur zentralen Prozessoreinheit (CPU) überträgt und/oder dass ein zweiter Ereignisgenerator (IO2) als Ein-/Ausgabeeinheit konfiguriert ist und Prozessorsignale zum ersten oder einem weiteren Ereignisanwender (EU1) weiterleitet.

9. Verfahren nach einem der Ansprüche 1-8, **dadurch gekennzeichnet, dass** die Ereignismeldungen (e1, e2) der Ereignisgeneratoren (EG) und/oder Aktionen der Ereignisanwender (EU) über einen Ereignismanager (EM) untereinander ausgetauscht werden und/oder dass Ereignismeldungen der Ereignisgeneratoren (EG) über den Ereignismanager (EM) zur zentralen Prozessoreinheit (CPU) übertragen werden und/oder dass Daten und Instruktionen von der zentralen Prozessoreinheit (CPU) über den Ereignismanager (EM) zu den Ereignisanwendern (EU) übertragen werden.

10. Verfahren nach einem der Ansprüche 1-9, **dadurch gekennzeichnet, dass** mittels 2. wenigstens eines der Ereignisgeneratoren (EG) das Auftreten der zugehörigen Adresse der zweiten Kommunikationseinheit (Z) innerhalb der ersten Signalfolge (SL) detektiert wird und nach Detektion dieser Adresse für die weiteren Ereignisse während der Datenübertragung der ersten Signalfolge (SL) Ereignismeldungen (e1, e2) erzeugt werden, die die Übertragung der zweiten Signalfolge (SZ) von der zweiten Kommunikationseinheit (Z) zur ersten Kommunikationseinheit (Z) auslösen.

11. Vorrichtung zur Übertragung von Daten nach dem Verfahren gemäss einem der Ansprüche 1-10, die Vorrichtung umfassend eine erste Kommunikationseinheit (L) und wenigstens eine zweite Kommunikationseinheit (Z), wobei zur Datenübertragung zwischen der ersten Kommunikationseinheit (L) und der zweiten Kommunikationseinheit (Z) die erste Kommunikationseinheit (L) und die zweite Kommunikationseinheit (Z) über eine Übertragungsleitung (W) miteinander verbunden sind, wobei die zweite Kommunikationseinheit (Z) eine zentrale Prozessoreinheit (CPU), eine Speichereinheit (M), in der ein Betriebsprogramm (OP) abgelegt ist, und wenigstens einen unabhängig von der zentralen Prozessoreinheit (CPU) arbeitenden ersten Ereignisgenerator (EG1) umfasst, mittels dessen über die Übertragungsleitung (W) zwischen den beiden Kommunikationseinheiten (L, Z) übertragene Signalfolgen (SLZ) überwachbar und für Ereignisse während der Datenübertragung, die für das angewendete Übertragungsprotokoll relevant sind, Ereignismeldungen (e1, e2) generierbar sind, die zur zentralen Prozessoreinheit (CPU) und/oder zu wenigstens einem Ereignisanwender (EU1) übertragbar sind.

12. Vorrichtung nach Anspruch 11, **dadurch gekennzeichnet, dass** die erste Kommunikationseinheit (L) eine Leseeinheit ist, mittels der während ersten Übertragungsphasen (TP1) ein Gleichspannungssignal oder ein Wechselspannungssignal als erste Signalfolge (SL) zur zweiten Kommunikationseinheit (Z) übertragbar ist, die als Zählereinheit ausgebildet ist, mittels der während zweiten Übertragungsphasen (TP2) Zählerdaten in einer zweiten Signalfolge (SZ) zur Leseeinheit (L) übertragbar sind.

13. Zählereinheit (Z) für eine Vorrichtung nach Anspruch 12 zur Übertragung von Daten nach dem Verfahren gemäss einem der Ansprüche 1-10 umfassend eine zentrale Prozessoreinheit (CPU), eine Speichereinheit (M), in der ein Betriebsprogramm (OP) abgelegt ist, und wenigstens einen unabhängig von der zentralen Prozessoreinheit (CPU) arbeitenden ersten Ereignisgenerator (EG1), mittels dessen über eine Übertragungsleitung (W) zwischen den beiden Kommunikationseinheiten (L, Z) übertragene Signalfolgen (SL, SZ) überwachbar und für Ereignisse während der Datenübertragung, die für das angewendete Übertragungsprotokoll relevant sind, Ereignismeldungen (e1, e2) generierbar sind, die zur zentralen Prozessoreinheit (CPU) und/oder zu wenigstens einem Ereignisanwender (EU1) übertragbar sind.

14. Zählereinheit (Z) nach Anspruch 13, **dadurch gekennzeichnet, dass** die Zählereinheit (Z) mehrere Ereignisgeneratoren (EG1, IO2) und mehrere Ereignisanwender (EU2, IO1) aufweist, die einerseits zur Steuerung der Datenübertragung und andererseits zur Kommunikation mit der zentralen Prozessoreinheit (CPU) vorgesehen sind.

15. Zählereinheit (Z) nach Anspruch 13, **dadurch gekennzeichnet, dass** die Ereignisgeneratoren (EG1, IO2) und die Ereignisanwender (EU2, IO1) sowie die zentrale Prozessoreinheit (CPU) in einem Prozessormodul (PM) integriert sind.

## Claims

1. A method for transmitting data signals in accordance with an applied transmission protocol, within at least one first and one second transmission phase (TP1, TP2), which follow one another synchronously or asynchronously, between a first communication unit (L) and at least one second communication unit (Z), which comprises a central processor unit (CPU) and a memory unit (M), in which an operating program (OP) is stored, **characterised in that** the second communication unit (Z) comprises at least one first event generator (EG1), which monitors signal sequences (SL, SLZ) transmitted via a transmission line (W) between the two communication units (L, Z) independently of the central processor unit (CPU) and generates event notifications (e1, e2) for events during the data transmission, which occur in accordance with the applied transmission protocol, which event notifications are transmitted to the central processor unit (CPU) and/or to at least one first event user (EU1).

2. The method according to Claim 1, **characterised in that** during the first transmission phase (TP1), a first signal sequence (SL) is transmitted from the first to the second communication unit (L; Z) and during the second transmission phase (TP2), a second signal sequence (SZ) is transmitted from the second to the first communication unit (Z; L), which is generated in the second communication unit (Z) by the central processor unit (CPU) or the first event user (EU1).

3. The method according to Claim 2, **characterised in that** to determine the change of the transmission phases (TP1, TP2), the first signal sequence (SL) is monitored and the edges of the corresponding envelope curve (EV) are determined and first and second event notifications (e1, e2) corresponding thereto are formed.

4. The method according to Claim 3, **characterised in that** the at least one first event generator (EG1) comprises a controllable filter (LPF), which is configured for each transmission phase (TP1, TP2) as required and which filters the signal sequences (SL, SZ) occurring on the transmission line (W) during each transmission phase (TP1, TP2) and forms a filtered signal (SF) which is free from interference and from the second signal sequence (SZ).

5. The method according to Claim 3 or 4, **characterised in that** a second event generator (EG2) is provided, which monitors the signal sequences (SL, SZ) occurring on the transmission line (W) or the filtered signal (SF) and determines signal edges, which signal a change of the transmission phase (TP1, TP2).

6. The method according to Claim 5, **characterised in that** the second event generator (EG2) comprises a first timer unit (C1), to which the filtered signal (SF) is supplied and which is reset in each case when a rising edge of the input signal (SF) occurs or when a time out is reached, wherein for each reset of the timer unit (C1), the state of the signal sequences (SL, SLZ) on the transmission line (W) or the filtered signal (SF) is scanned, a state change is determined and the first or second event notification (e1, e2) corresponding thereto is formed.

7. The method according to one of Claims 3-6, **characterised in that** the first event user (EU1) is started by means of the first event notification (e1) and generates the second signal sequence (SZ), until it is stopped by means of the second event notification (e2), and/or **in that** the limit frequency of the low-pass filter (LPF) in the first event generator (EG1) is lowered after the completion of the first transmission phase (TP1) by means of the first event notification (e1) and increased after the completion of the second transmission phase (TP2) by means of the second event notification (e2), so that the limit frequency of the low-pass filter (TPF) within the second transmission phase (TP2) is lower than the frequency of the second signal sequence (SZ) and the same can be blocked.

8. The method according to one of Claims 1-7, **characterised in that** at least one second event user (101) is configured as an in-/output unit and preferably transmits event notifications (e1, e2) via an interrupt input to the central processor unit (CPU) and/or **in that** a second event generator (102) is configured as an in-/output unit and forwards processor signals to the first or a further event user (EU1).

9. The method according to one of Claims 1-8, **characterised in that** the event notifications (e1, e2) of the event generators (EG) and/or actions of the event users (EU) are exchanged with one another via an event manager (EM) and/or **in that** event notifications of the event generators (EG) are transmitted via the event manager (EM) to the central processor unit (CPU) and/or **in that** data and instructions are transmitted from the central processor unit (CPU) via the event manager (EM) to the event users (EU).

10. The method according to one of Claims 1-9, **characterised in that** the occurrence of the associated address of the second communication unit (Z) is detected within the first signal sequence (SL) by means of at least one of the event generators (EG) and after the detection of this address, event notifications (e1, e2) are generated for the further events during the data transmission of the first signal sequence (SL), which event notifications trigger the transmission of the second signal sequence (SZ) from the second communication unit (Z) to the first communication unit (Z).

11. A device for transmitting data according to the method according to one of Claims 1-10, the device comprising a first communication unit (L) and at least one second communication unit (Z), the first communication unit (L) and the second communication unit (Z) being connected to one another via a transmission line (W) for data transmission between the first communication unit (L) and the second communication unit (Z), the second communication unit (Z) comprising a central processor unit (CPU), a memory unit (M), in which an operating program (OP) is stored, and at least one event generator (EG1) operating independently of the central processor unit (CPU), by means of which signal sequences (SLZ) transmitted via the transmission line (W) between the two communication units (L, Z) can be monitored and event notifications (e1, e2) can be generated for events during data transmission, which are relevant for the applied transmission protocol, which event notifications can be transmitted to the central processor unit (CPU) and/or to at least one event user (EU1).

12. The device according to Claim 11, **characterised in that** the first communication unit (L) is a reading unit, by means of which during first transmission phases (TP1), a DC voltage signal or an AC voltage signal can be transmitted as first signal sequence (SL) to the second communication unit (Z), which is constructed as a counter unit, by means of which, during the second transmission phases (TP2), counter data can be transmitted in a second signal sequence (SZ) to the reading unit (L).

13. A counter unit (Z) for a device according to Claim 12 for transmitting data according to the method according to one of Claims 1-10, comprising a central processor unit (CPU), a memory unit (M), in which an operating program (OP) is stored, and at least one first event generator (EG1) operating independently of the central processor unit (CPU), by means of which signal sequences (SL, SZ) transmitted via a transmission line (W) between the two communication units (L, Z) can be monitored and event notifications (e1, e2) can be generated for events during data transmission, which are relevant for the applied transmission protocol, which event notifications can be transmitted to the central processor unit (CPU) and/or to at least one event user (EU1).

14. The counter unit (Z) according to Claim 13, **characterised in that** the counter unit (Z) has a plurality of event generators (EG1, 102) and a plurality of event users (EU2, 101), which are provided on the one hand for controlling the data transmission and on the other hand for communication with the central processor unit (CPU).

15. The counter unit (Z) according to Claim 13, **characterised in that** the event generators (EG1, 102) and the event users (EU2, 101) as well as the central processor unit (CPU) are integrated in a processor module (PM).

## Revendications

1. Procédé, destiné à transmettre des signaux de données selon un protocole de transmission appliqué au sein d'au moins une première et une deuxième phase de transmission (TP1, TP2), qui se suivent de manière synchrone ou asynchrone, entre une première unité de communication (L) et au moins une deuxième unité de communication (Z) qui comprend une unité centrale de processeur (CPU) et une unité de mémoire (M), dans laquelle est sauvegardé un programme d'exploitation (OP), **caractérisé en ce que** la deuxième unité de communication (Z) comprend au moins un premier générateur d'événement (EG1), qui par l'intermédiaire d'une ligne de transmission (W) entre les deux unités de communication (L, Z) supervise des séquences de signaux (SL, SLZ) transmises, indépendamment de l'unité centrale de processeur (CPU) et pour des événements pendant la transmission de données qui surviennent conformément au protocole de transmission appliqué, génère des messages d'événement (e1, e2), qui sont transmis vers l'unité centrale de processeur (CPU) et / ou vers au moins un premier utilisateur d'événement (EU1).

2. Procédé selon la revendication 1, **caractérisé en ce que** pendant la première phase de transmission (TP1), une première séquence de signaux (SL) est transmise de la première vers la deuxième unité de communication (L ; Z) et pendant la deuxième phase de transmission (TP2), une deuxième séquence de signaux (SZ) est transmise de la deuxième vers la première unité de communication (Z ; L), qui dans la deuxième unité de communication (Z) est générée par l'unité centrale de processeur (CPU) ou par le premier utilisateur d'événement (EU1).

3. Procédé selon la revendication 2, **caractérisé en ce que** pour déterminer le changement de la phase de transmission (TP1, TP2), la première séquence de signaux (SL) est supervisée et les flancs de la courbe enveloppante (EV) correspondante sont déterminés et des premiers et deuxièmes messages d'événements (e1, e2) sont générés.

4. Procédé selon la revendication 3, **caractérisé en ce que** l'au moins un premier générateur d'événement (EG1) comprend un filtre (LPF) susceptible d'être commandé, qui pour chaque phase de transmission (TP1, TP2) est configuré en fonction des besoins et qui pendant chaque phase de transmission (TP1, TP2) filtre les séquences de signaux (SL, SZ) qui surviennent sur la ligne de transmission (W) et créé un signal (SF) filtré qui est libéré de perturbations et de la deuxième séquence de signaux (SZ).

5. Procédé selon la revendication 3 ou 4, **caractérisé en ce qu'**il est prévu un deuxième générateur d'événement (EG2) qui supervise les séquences de signaux (SL, SZ) qui surviennent sur la ligne de transmission (W) ou le signal filtré (SF) et qui détermine des flancs de signaux qui signalent un changement de la phase de transmission (TP1, TP2).

6. Procédé selon la revendication 5, **caractérisé en ce que** le deuxième générateur d'événement (EG2) comprend une première unité de temporisation (C1), vers laquelle est amené le signal (SF) filtré et qui est réinitialisée lorsque survient un flanc montant du signal d'entrée (SF) ou lorsqu'un timeout est atteint, pour chaque réinitialisation de l'unité de temporisation (C1), l'état des séquences de signaux (SL, SLZ) sur la ligne de transmission (W) ou le signal (SF) filtré étant balayé, un changement d'état étant déterminé et le premier ou le deuxième message d'événement (e1, e2) correspondant étant créé.

7. Procédé selon l'une quelconque des revendications 3 à 6, **caractérisé en ce que** le premier utilisateur d'événement (EU1) est démarré au moyen du premier message d'événement (e1) et génère la deuxième séquence de signaux (SZ), jusqu'à ce qu'il soit arrêté au moyen du deuxième message d'événement (e2) et/ou **en ce qu'**après l'achèvement de la première phase de transmission (TP1), la fréquence limite du filtre passe-bas (LPF) dans le premier générateur d'événement (EG1) est baissée au moyen du premier message d'événement (e1) et après l'achèvement de la deuxième phase de transmission (TP2), est relevée au moyen du deuxième message d'événement (e2), de telle sorte que la fréquence limite du filtre passe-bas (TPF) au sein de la deuxième phase de transmission (TP2) soit inférieure à la fréquence de la deuxième séquence de signaux (SZ) et qu'elle puisse être bloquée.

8. Procédé selon l'une quelconque des revendications 1 à 7, **caractérisé en ce qu'**au moins un deuxième utilisateur d'événement (101) est configuré en tant qu'unité de saisie / d'édition et transmet des messages d'événement (e1, e2), de préférence par l'intermédiaire d'une entrée d'interruption vers l'unité centralisée de processeur (CPU) et / ou **en ce qu'**un deuxième générateur d'événement (102) est configuré en tant qu'unité de saisie / d'édition et retransmet des signaux du processeur vers le premier ou vers un autre utilisateur d'événement (EU1).

9. Procédé selon l'une quelconque des revendications 1 à 8, **caractérisé en ce que** les messages d'événement (e1, e2) des générateurs d'événement (EG) et / ou des actions des utilisateurs d'événement (EU) sont échangé(e)s entre eux (elles) par l'intermédiaire d'un gestionnaire d'événement (EM) et / ou **en ce que** des messages d'événement des générateurs d'événement (EG) sont transmis par l'intermédiaire du gestionnaire d'événement (EM) vers l'unité centrale de processeur (CPU) et / ou **en ce que** des données et des instructions sont transmises par l'unité centrale de processeur (CPU) vers les utilisateurs d'événement (EU), par l'intermédiaire du gestionnaire d'événement (EM).

10. Procédé selon l'une quelconque des revendications 1 à 9, **caractérisé en ce qu'**au moyen d'au moins l'un des générateurs d'événement (EG), la survenance de l'adresse associée de la deuxième unité de communication (Z) au sein de la première séquence de signaux (SL) est détectée et après la détection de ladite adresse, des messages d'événement (e1, e2) qui déclenchent la transmission de la deuxième séquence de signaux (SZ) de la deuxième unité de communication (Z) vers la première unité de communication (Z) sont générés pour les autres événements pendant la transmission des données de la première séquence de signaux (SL).

11. Dispositif, destiné à transmettre des données d'après le procédé selon l'une quelconque des revendications 1 à 10, le dispositif comprenant une première unité de communication (L) et au moins une deuxième unité de communication (Z), pour la transmission de données entre la première unité de communication (L) et la deuxième unité de communication (Z), la première unité de communication (L) et la deuxième unité de communication (Z) étant connectées l'une à l'autre par l'intermédiaire d'une ligne de transmission (W), la deuxième unité de communication (Z) comprenant une unité centrale de processeur (CPU), une unité de mémoire (M) dans laquelle est sauvegardé un programme d'exploitation (OP) et au moins un générateur d'événement (EG1) travaillant indépendamment de l'unité centrale de processeur (CPU), au moyen duquel par l'intermédiaire de la ligne de transmission (W), des séquences de signaux (SLZ) transmises entre les deux unités de communication (L, Z) peuvent être supervisées et pour des événements qui sont déterminants pour la protocole de transmission appliqué, des messages d'événement (e1, e2) peuvent être générés, qui peuvent être transmis vers l'unité centrale de processeur (CPU) et / ou vers au moins un utilisateur d'événement (EU1).

12. Dispositif selon la revendication 11, **caractérisé en ce que** la première unité de communication (L) est une unité de lecture, au moyen de laquelle pendant des premières phases de transmission (TP1), un signal de tension continue ou un signal de tension alternative est susceptible d'être transmis en tant que première séquence de signaux (SL) vers la deuxième unité de communication (Z), qui est conçue en tant qu'unité informatique, au moyen de laquelle pendant des deuxièmes phases de transmission (TP2), des données informatiques peuvent être transmises vers l'unité de lecture (L) dans une deuxième séquence de signaux (SZ).

13. Unité informatique (Z) destinée à un dispositif selon la revendication 12, pour la transmission de données d'après le procédé selon l'une quelconque des revendications 1 à 10, comprenant une unité centrale de processeur (CPU), une unité de mémoire (M) dans laquelle est sauvegardé un programme d'exploitation et au moins un premier générateur d'événement (EG1) travaillant indépendamment de l'unité centrale de processeur (CPU), au moyen duquel, par l'intermédiaire d'une ligne de transmission (W), des séquences de signaux (SL, SZ) transmises entre les deux unités de communication (L, Z) peuvent être supervisées et pour des événements pendant la transmission de données qui sont déterminantes pour le protocole de transmission appliqué, des messages d'événement (e1, e2) peuvent être générés, qui peuvent être transmis vers l'unité centrale de processeur (CPU) et / ou vers au moins un utilisateur d'événement (EU1).

14. Unité informatique (Z) selon la revendication 13, **caractérisée en ce que** l'unité informatique (Z) comporte plusieurs générateurs d'événement (EG1, 102) et plusieurs utilisateurs d'événement (EU2, 101), qui sont prévus d'une part pour commander la transmission de données et d'autre part pour la communication avec l'unité centrale de processeur (CPU).

15. Unité informatique (Z) selon la revendication 13, **caractérisée en ce que** les générateurs d'événement (EG1, 102) et les utilisateurs d'événement (EU3, 101), ainsi que l'unité centrale de processeur (CPU) sont intégrés dans un module de processeur (PM).
